# FASCICULE DE BREVET EUROPEEN

(11) **EP 0 997 740 B1**
(45) Date de publication et mention de la délivrance du brevet: **31.05.2006**
(21) Numéro de dépôt: 99402687.0
(22) Date de dépôt: 28.10.1999
(51) Int. Cl.: G01R 31/04, G06K 19/077, G01N 3/20

(54) **Appareil de test pour cartes à mémoire électronique**
Testanordnung für elektronische Speicherkarten
Test appliance for electronic memory cards

(30) Priorité: 28.10.1998 FR 9813501
(43) Date de publication de la demande: 03.05.2000
(73) Titulaire: Axalto S.A., 92120 Montrouge (FR)
(72) Inventeur: Reignoux, Yves, 45380 La Chapelle St Mesmin (FR); Limelette, Yann, 45430 Mardie (FR)
(74) Mandataire: Cassagne, Philippe M.J.

(56) Documents cités:
- EP-A- 0 704 819
- WO-A-79/00543
- DE-C- 19 620 550
- PATENT ABSTRACTS OF JAPAN vol. 8, no. 1 (P-246) [1438], 6 janvier 1984 (1984-01-06) & JP 58 166272 A (HITACHE)
- PATENT ABSTRACTS OF JAPAN vol. 7, no. 241 (P-232) [1386], 26 octobre 1983 (1983-10-26) & JP 58 127176 A (NIPPON DENKI K.K.)

## Description

La présente invention a pour objet un appareil de test pour cartes à mémoire électronique du type comprenant un corps de carte dans lequel est fixé un module électronique qui comprend une pastille semi-conductrice dans laquelle sont réalisés des circuits intégrés et des plages externes de contact électrique.

Le corps de la carte est constitué par une plaque de matériau, par exemple plastique du type PVC ou ABS dont l'épaisseur est de l'ordre de 0,8 mm et dont les dimensions sont de l'ordre de 50 mm par 80 mm.

Pour permettre l'utilisation aisée de ces cartes par leurs détenteurs, il est nécessaire que lors des manipulations normales de la carte, celle-ci ne subisse pas des déformations qui en rendrait l'usage impossible ou qui viendrait à altérer le fonctionnement de cette carte. Ces défauts peuvent consister dans une prise anormale de flèche du corps de la carte rendant son insertion dans les lecteurs impossible ou des problèmes liés au module électronique et qui peuvent consister soit, dans le décollement du module électronique par rapport au corps de carte, soit encore, dans une altération du module électronique entraînant soit, une rupture de certaines liaisons électriques, soit , une destruction partielle de la pastille semi-conductrice.

Pour s'assurer que les cartes fabriquées permettent effectivement une utilisation normale, la norme ISO a prévu un certain nombre de tests, notamment en flexion et en torsion du corps de la carte. D'une part, ces tests sont relativement peu efficaces en raison de l'amélioration des techniques de fabrication de ces cartes et d'autre part, ces tests ne sont pas toujours très représentatifs des conditions d'utilisation réelles des cartes et notamment des contraintes auxquelles elles peuvent être soumises lors de leur utilisation.

C'est pourquoi les constructeurs ont mis au point des tests qui leur sont propres et qui permettent de se rapprocher autant que faire se peut des conditions réelles d'utilisation, tel que par exemple dans EP-A-O 704 819 ou DE 196 20 550C.

La présente invention a pour objet de fournir un appareil de test qui permette la mise en oeuvre de tests de tenue mécanique et fonctionnelle de la carte et surtout des circuits du module électronique.

Pour atteindre ce but, selon un premier objet de la présente invention, l'appareil de test pour cartes à mémoire électronique comprenant un corps de carte présentant une première et une deuxième face et un module électronique comportant une pastille semi-conductrice dans laquelle sont réalisés des circuits intégrés, et une pluralité de plages externes de contact électrique raccordées à ladite pastille et disposées dans ladite première face.
L'appareil de test comprend en outre :
- des moyens de supportage et de positionnement de la carte comprenant deux éléments longitudinaux de supportage d'une face de la carte disposés de telle manière que ledit module électronique soit placé entre lesdits éléments longitudinaux,
- un outil mobile selon une direction orthogonale au plan du corps de carte pour appliquer au droit dudit module électronique une force d'intensité croissante,
- des moyens de contrôle pour appliquer audit module électronique des signaux électriques de commande et pour recevoir les signaux délivrés par ledit module en réponse auxdits signaux de commande,
- des moyens de test pour comparer les signaux reçus à des signaux de référence de fonctionnement correct des circuits intégrés du module électronique à chaque instant que la force est appliquée, et pour enregistrer au moins l'intensité de la force appliquée par l'outil lorsque les signaux reçus deviennent différents des signaux de référence.

Selon un second objet de la présente invention, le procédé de test pour cartes à mémoire électronique comprenant un corps de carte présentant une première et une deuxième face et un module électronique comportant une pastille semi-conductrice dans laquelle sont réalisés des circuits intégrés, et une pluralité de plages externes de contact électrique raccordées à ladite pastille et disposées dans ladite première face comporte les étapes selon lesquelles :
- on soumet la carte à une contrainte en flexion et en compression en positionnant la carte sur des moyens de supportage et de positionnement comprenant deux éléments longitudinaux de supportage d'une face de la carte disposés de telle manière que ledit module électronique soit placé entre lesdits éléments longitudinaux, et en appliquant, au moyen d'un outil mobile selon une direction orthogonale au plan du corps de carte au droit dudit module électronique, une force d'intensité croissante,
- grâce à des moyens de contrôle, on applique audit module électronique des signaux électriques de commande et on reçoit les signaux délivrés par ledit module en réponse auxdits signaux de commande,
- on compare les signaux reçus à des signaux de référence de fonctionnement correct des circuits intégrés du module électronique à chaque instant que la force est appliquée, et on enregistre au moins l'intensité de la force appliquée par l'outil lorsque les signaux reçus deviennent différents des signaux de référence.

On comprend que, grâce au principe mis en oeuvre par l'appareil de test, la carte et plus particulièrement son module électronique sont soumis à des contraintes mécaniques jusqu'à ce que l'on détecte le seuil correspondant à l'arrêt du fonctionnement normal du module électronique. L'enregistrement d'au moins la force appliquée correspondant à cette situation permet d'évaluer les qualités de la technique de fabrication de la carte ou de contrôler que des cartes fabriquées se trouvent bien dans une plage de caractéristiques permettant leur usage normal évitant ainsi les retours de terrains nombreux.

Selon un premier mode de mise en oeuvre, de préférence, la partie de l'outil destinée à être appliquée sur la carte au droit du module électronique a la forme d'une surface hémicylindrique de faible rayon. On réalise ainsi l'application au module et à la carte d'une contrainte selon les génératrices de la surface hémicylindrique en appui sur le module.

Selon un autre mode de mise en oeuvre, la portion de l'outil destinée à être appliquée sur la carte au droit du module électronique est une surface plane circulaire recouverte par une couche d'un matériau légèrement déformable.

De préférence, ces deux outils de test sont utilisés afin de soumettre la carte à des contraintes représentatives des conditions actuelles d'utilisation.

D'autres caractéristiques et avantages de l'invention apparaîtront mieux à la lecture de la description qui suit de plusieurs modes de réalisation de l'invention donné à titre d'exemple non limitatif. La description se réfère aux figures annexées sur lesquelles :
- la figure 1 est une vue de dessus simplifiée montrant une carte placée dans l'appareil de test ;
- la figure 2 est une vue simplifiée de l'ensemble de l'appareil de test ;
- la figure 3a est une vue plus détaillée de l'appareil de test utilisant un premier outil de test ; et
- la figure 3b est une vue partielle montrant un deuxième outil de test utilisable dans l'appareil.

Comme on l'a déjà expliqué, le principe de l'invention consiste à soumettre la carte et plus particulièrement son module électronique à une contrainte qui va en augmentant tout en contrôlant en permanence le bon fonctionnement électrique du module électronique. Préférentiellement, le taux de la force appliquée progresse dans un intervalle qui est de l'ordre de 0 à 300 Newton suivant la nature de la carte testée. Lorsque ce bon fonctionnement cesse, on enregistre au moins la force qui a entraîné cette disparition du bon fonctionnement.

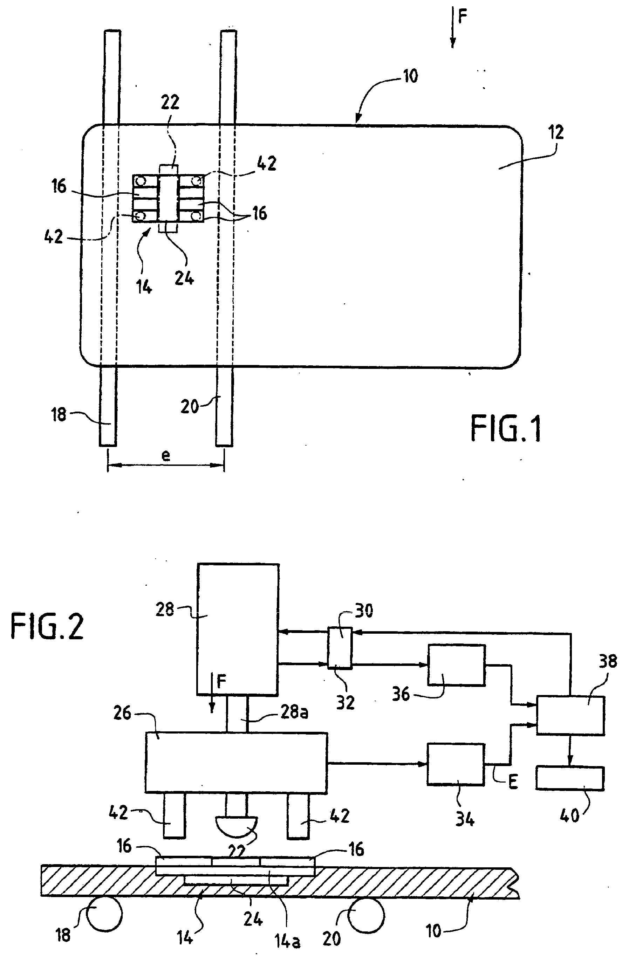

Sur la figure 1, on a représenté en vue de dessus une carte à mémoires électronique 10 avec son corps en matériau plastique 12 et son module électronique 14 dont on voit les plages externes de contact électrique 16. Pour effectuer les tests, la carte est posée sur deux supports longitudinaux horizontaux et parallèles entre eux 18 et 20 dont l'écartement e est tel que le corps de carte repose sur les éléments de support 18 et 20 de part et d'autre du module électronique 14. A l'aide de l'appareil de test, on applique une contrainte F, à l'aide d'un outil symbolisé par 22 exerçant cette contrainte au niveau du module électronique 14. Avantageusement, les éléments de support longitudinaux 18 et 20 ont une forme cylindrique comme le montre la figure 2. Lorsque la carte est soumise à la force F, elle fléchit. Cette flexion est facilitée grâce à la forme cylindrique des éléments de support 18 et20. C'est ainsi que l'on soumet la carte à une contrainte en flexion et en compression. Ladite contrainte modélise par exemple une contrainte qui est appliquée par un utilisateur de la carte lorsqu'il tient le corps de carte entre un index et un pouce d'une même main et qu'il appuie avec son autre pouce sur le module. Bien entendu, ledit utilisateur peut appuyer indifféremment sur l'une ou l'autre face de la carte.

La figure 2 représente de façon schématique l'ensemble de l'appareil de mesure. On retrouve la carte 10 avec son module électronique 14, ses plages externes de contact 16 et la pastille semi-conductrice 24 dans laquelle sont réalisés les circuits intégrés du module électronique, ces circuits étant reliés par des connexions aux plages externes 16. On retrouve également sur la figure 2 les deux éléments de support longitudinaux et horizontaux 18 et 20. Sur cette figure, on a représenté également l'outil de test 22 qui est fixé sur une tête de test 26 solidaire d'un dispositif 28 apte à appliquer l'outil 22 avec une force croissant progressivement. Par exemple, le dispositif 28 est constitué par un vérin, la tête 26 étant solidaire de la tige 28a de ce vérin. Au vérin 28 est associé un dispositif de commande de ce vérin 30 qui permet d'appliquer à chaque instant une force pour obtenir une vitesse de déformation prédéterminée, ce circuit de commande 30 étant également apte à mesurer par sa partie 32 la course de l'outil 22 c'est-à-dire la déformation mécanique de la carte.

L'appareil de test comporte également des circuits électroniques ou électriques parmi lesquels on trouve un circuit 34 d'alimentation et de dialogue avec les circuits intégrés de la carte, un circuit 36 d'élaboration de signaux représentatifs à chaque instant de la force F appliquée et de la course C, un circuit de traitement 38 qui reçoit d'une part, un signal délivré par le circuit 34 et d'autre part, les informations d'intensité de force F et de course C et un circuit 40 d'enregistrement d'informations. Le circuit 34 d'alimentation et de test est relié aux plages externes 16 de la carte par des contacts électriques tels que 42 qui sont de préférence portés par la tête 26. Ainsi, lorsque l'outil de test 22 arrive en contact avec la face supérieure 14a du module électronique, les contacts 42 assurent une connexion électrique entre les plages 16 du module électronique et le circuit 34. Le circuit 34 sert à alimenter les circuits intégrés de la pastille 24 et à appliquer des signaux de commande à ces circuits intégrés. Conformément au fonctionnement normal du module électronique, des signaux de réponse sont élaborés et appliqués par la pastille semi-conductrice aux plages de contact externe 16, ces signaux étant recueillis par le circuit 34. Dans le circuit 34, il est prévu des circuits de comparaison entre les signaux de réponse effectivement reçus et des signaux de référence correspondant au fonctionnement normal du module électronique qui sont mémorisés dans le circuit 34. Lorsque ces circuits de comparaison détectent une différence entre les signaux de référence et les signaux effectivement reçus, il émet un signal d'erreur E qui est appliqué au circuit de traitement 38. La détection de ce signal E entraîne l'interruption de l'application de la force F et l'enregistrement de la valeur de la force F et de la course C. Par exemple, on applique un signal de commande permettant d'obtenir une réponse à une remise à zéro de la carte, appelée couramment dans le langage anglo-saxon "answer to reset". Si la réponse est mauvaise, on en déduit que la pastille a été détériorée par la force F appliquée. Ainsi, on vérifie en temps réel le fonctionnement de la carte. Grâce à ce test, il est possible de savoir si la pastille 24 est dégradée ou non, par exemple si elle comporte une fêlure. En effet, la pastille étant enfermée dans le module, une simple fêlure de quelques microns n'est visible ni à l'oeil nu ni avec un microscope courant.

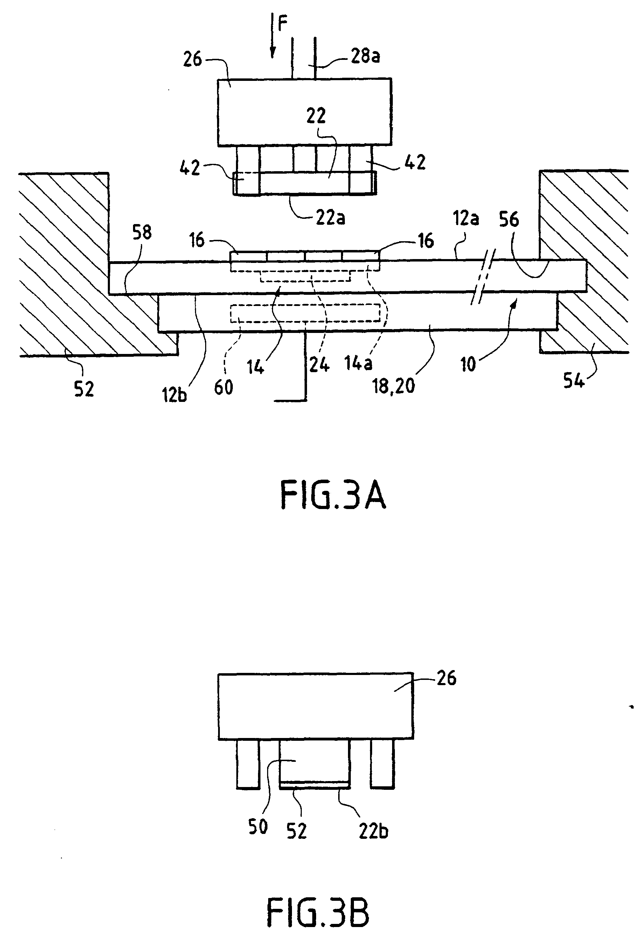

Comme le montre mieux la figure 3a, l'outil 22 référencé 22a peut être constitué par une surface hémicylindrique dont la longueur est, préférentiellement, au moins égale à celle du module électronique et dont le rayon de courbure est de l'ordre de un millimètre.

L'outil de test 22b, montré sur la figure 3b est constitué par un cylindre 50 de diamètre égal à, de préférence, environ 4 mm et dont la face d'extrémité active est recouverte par une couche en silicone ou matériau analogue 52 d'épaisseur environ 0,8 mm. Ainsi, de préférence, la surface d'appui de l'outil 22b est de l'ordre de la surface de la goutte d'enrobage recouvrant la pastille semi-conductrice comprise dans le module électronique. La couche de silicone permet avantageusement d'amortir le contact de l'outil de test avec le module électronique.

Ces deux outils 22a et 22b sont utilisés sur les deux faces principales 12a et 12b d'une carte. Préférentiellement, on teste en alternance un ensemble de cartes avec le premier outil 22a et un autre ensemble de cartes avec le deuxième outil 22b, et, de préférence, dans un même ensemble de cartes, on teste au choix la première ou la deuxième face d'une carte jusqu'à ce que la carte se dégrade, puis on teste une autre carte et ainsi de suite. On reconstitue ainsi des conditions proches des conditions d'utilisation réelles, ce qui permet d'obtenir des résultats de test représentatifs de l'utilisation effective des cartes.

Sur la figure 3a, on a représenté plus en détails la partie mécanique de l'appareil de test. On retrouve les éléments longitudinaux 18 et 20 qui sont fixés entre deux pièces 52 et 54 de positionnement de la carte. La pièce 54 présente une rainure 56 pour l'engagement d'un bord du corps de carte 12, alors que la pièce 52 comporte un épaulement 58 sur lequel repose l'autre bord de la carte. On positionne la carte en la coulissant dans la rainure 56. Une butée, non représentée, assure le positionnement longitudinal de la carte. Des plots de connexion électrique 60 sont prévus entre les éléments longitudinaux 18 et 20 pour assurer la connexion électrique entre les circuits de la carte et les circuits 34 de la machine de test lorsque la face supérieure 12a repose sur les éléments longitudinaux de supportage, c'est à dire lorsqu'on teste la carte en appliquant la force F sur la deuxième face de la carte.

On notera que le fait d'avoir les contacts électriques 42 solidaires des moyens appliquant la force F et de l'outil 22 facilite le test décrit précédemment. En effet si les contacts électriques n'étaient pas solidaires de l'outil 22 et de la tête 26 mobiles, l'établissement d'un contact électrique en continu pendant ledit test serait plus ardu, la carte se déplaçant sous l'effet de la force appliquée.

Enfin, on notera que l'appareil de test décrit selon l'invention, permet également de tester une carte sans aller obligatoirement jusqu'à une rupture. Cela permet de tester des cartes qui marchent fonctionnellement mais dont un des éléments constituant est cassé. On déforme la carte en appliquant une légère contrainte sans aller jusqu'à une rupture. Si la carte fonctionne toujours, cela veut dire qu'elle n'est pas cassée. Dans le cas contraire, elle est cassée et on la rejette.

## Revendications

1. Appareil de test pour cartes à mémoire électronique comprenant un corps de carte (12) présentant une première et une deuxième face et un module électronique (14) comportant une pastille semi-conductrice(24) dans laquelle sont réalisés des circuits intégrés, et une pluralité de plages externes (16) de contact électrique raccordées à ladite pastille (24) et disposées dans ladite première face, ledit appareil comprenant :
- des moyens de supportage et de positionnement (18, 20, 52, 54) de la carte comprenant deux éléments longitudinaux de supportage (18, 20) d'une face de la carte disposés de telle manière que ledit module électronique (14) soit placé entre lesdits éléments longitudinaux,
- un outil mobile (22) selon une direction orthogonale au plan du corps de carte (12) pour appliquer au droit dudit module électronique (14) une force (F) d'intensité croissante,
- des moyens de contrôle(42) pour appliquer audit module électronique (14) des signaux électriques de commande et pour recevoir les signaux délivrés par ledit module en réponse auxdits signaux de commande, ledit appareil étant **caractérisée en ce qu'**il comprend en outre;
- des moyens de test (34, 36, 38, 40) pour comparer les signaux reçus à des signaux de référence de fonctionnement correct des circuits intégrés du module électronique à chaque instant que la force est appliquée, et pour enregistrer au moins l'intensité de la force appliquée par l l'outil lorsque les signaux reçus deviennent différents des signaux de référence.

2. Appareil de test selon la revendication 1, **caractérisé en ce qu'**il comporte en outre :
- des moyens (42) pour alimenter ledit module électronique.

3. Appareil de test selon la revendication 2, **caractérisé en ce qu'**il comporte en outre :
- des moyens de connexion (42) pour relier les plages externes de la carte aux moyens d'alimentation et de contrôle.

4. Appareil de test selon l'une quelconque des revendications 1 à 3, **caractérisé en ce qu'**il comporte en outre :
- des moyens (28) pour appliquer audit outil ladite force.

5. Appareil de test selon l'une quelconque des revendications 1 à 4, **caractérisé en ce que** les moyens de test comprennent en outre des moyens (40) pour enregistrer la valeur de la course de l'outil lorsque lesdits signaux reçus sotn différents des signaux de référence.

6. Appareil de test selon l'une quelconque des revendications 1 à 5, **caractérisé en ce que** la partie de l'outil destinée à être appliquée sur la carte au droit du module électronique a la forme d'une surface hémicylindrique de faible rayon.

7. Appareil de test selon l'une quelconque des revendications 1 et 5, **caractérisé en ce que** la partie de l'outil destinée à être appliquée sur la carte au droit d'un module électronique est une surface plane circulaire recouverte par une couche d'un matériau légèrement déformable.

8. Appareil de test selon l'une quelconque des revendications 3 à 7, **caractérisé en ce que** lesdits moyens de connexion comprennent des contacts électriques solidaires des moyens pour appliquer la force afin d'établir la connexion électrique avec les plages externes de la carte lorsque celle-ci repose sur les éléments longitudinaux de supportage par sa deuxième face.

9. Appareil de test selon l'une quelconque des revendications 3 à 7, **caractérisé en ce que** lesdits moyens de connexion comprennent des contacts électriques fixes disposés entre les deux éléments longitudinaux de supportage pour établir une connexion électrique avec les plages externes de la carte lorsque ladite carte repose sur les éléments longitudinaux de supportage par sa première face.

10. Appareil de test selon l'une quelconque des revendications 1 à 9, **caractérisé en ce que** lesdits éléments de supportage longitudinaux ont une forme cylindrique.

11. Procédé de test pour cartes à mémoire électronique comprenant un corps de carte (12) présentant une première et une deuxième face et un module électronique (14) comportant une pastille semi-conductrice (24) dans laquelle sont réalisés des circuits intégrés, et une pluralité de plages externes (16) de contact électrique raccordées à ladite pastille et disposées dans ladite première face, comporte les étapes selon lesquelles :
- on soumet la carte à une contrainte en flexion et en compression en positionnant la carte sur des moyens de supportage (18, 20) et de positionnement (52, 54) comprenant deux éléments longitudinaux de supportage d'une face de la carte disposés de telle manière que ledit module électronique soit placé entre lesdits éléments longitudinaux, et en appliquant, au moyen d'un outil mobile (22) selon une direction orthogonale au plan du corps de carte au droit dudit module électronique, une force d'intensité croissante,
- grâce à des moyens de contrôle (42), on applique audit module électronique (14) des signaux électriques de commande et on reçoit les signaux délivrés par ledit module en réponse auxdits signaux de commande, **caractérisé en ce qu'**il comporte en outre l'étape selon laquelle:
- on compare les signaux reçus à des signaux de référence de foncitonnement correct des circuits intégrés du module électronique à chaque instant que la force est appliquée et on enregistre au moins l'intensité de la force (F) appliquée par l'outil lorsque les signaux reçus deviennent différents des signaux de référence.

12. Procédé de test selon la revendication 11, **caractérisé en ce qu'**il comporte une étape supplémentaire selon laquelle on alimente ledit module électronique grâce à des moyens d'alimentation.

13. Procédé de test selon la revendication 12, **caractérisé en ce qu'**il comporte une étape supplémentaire selon laquelle on connecte les plages externes de la carte aux moyens d'alimentation et de contrôle, grâce à des moyens de connexion.

14. Procédé de test selon l'une quelconque des revendications 11 à 13, **caractérisé en ce qu'**on utilise des moyens (28) pour appliquer audit outil ladite force.

15. Procédé de test selon l'une quelconque des revendications 11 à 14, **caractérisé en ce qu'**il comporte une étape supplémentaire selon laquelle on enregistre la valeur de la course de l'outil lorsque lesdits signaux reçus sont différents des signaux de référence.

16. Procédé de test selon l'une quelconque des revendications 11 à 15, **caractérisé en ce que** la partie de l'outil (22) destinée à être appliquée sur la carte au droit du module électronique a la forme d'une surface hémicylindrique de faible rayon.

17. Procédé de test selon l'une quelconque des revendications 11 à 15, **caractérisé en ce que** la partie de l'outil destinée à être appliquée sur la carte au droit d'un module électronique est une surface plane circulaire recouverte par une couche d'un matériau légèrement déformable.

18. Procédé de test selon l'une quelconque des revendications 13 à 17, **caractérisé en ce que** lesdits moyens de connexion comprennent des contacts électriques solidaires des moyens pour appliquer la force afin d'établir la connexion électrique avec les plages externes de la carte lorsque celle-ci repose sur les éléments longitudinaux de supportage par sa deuxième face.

19. Procédé de test selon l'une quelconque des revendications 13 à 17, **caractérisé en ce que** lesdits moyens de connexion comprennent des contacts électriques fixes disposés entre les deux éléments longitudinaux de supportage pour établir une connexion électrique avec les plages externes de la carte lorsque ladite carte repose sur les éléments longitudinaux de supportage par sa première face.

20. Procédé de test selon l'une quelconque des revendications 11 à 19, **caractérisé en ce que** lesdits éléments de supportage longitudinaux ont une force cylindrique.

## Claims

1. Test apparatus for electronic memory cards each comprising a card body (12) having first and second faces and an electronic module (14) comprising both a semiconductor chip (24) in which integrated circuits are formed, and also a plurality of external electrical contact areas (16) connected to said chip and located in said first face, said apparatus comprising:
· means for support and positioning (18, 20, 52, 54), of the card comprising two longitudinal support elements (18, 20) for supporting one face of the card and disposed in such a manner that said electronic module (14) is placed between said longitudinal elements,
· a moving tool (22) that moves in a direction orthogonal to the plane of the card body (12) to apply an increasing force (F) perpendicular to said electronic module (14),
· means of control (42) for applying electrical control signals to said electronic module (14), and for receiving the signals delivered by said module in response to said electrical control signals, said apparatus being **characterized in that** it further comprises:
· test means (34, 36, 38, 40) for comparing the signals received with reference signals representative of the integrated circuits in the electronic module operating correctly at all times that the force is being applied, and for recording at least the magnitude of the force applied by the tool when the received signals become different from the reference signals.

2. Test apparatus according to claim 1, **characterized in that** it further comprises:
- means (42) to supply power to said electronic module.

3. Test apparatus according to claim 2, **characterized in that** it further comprises:
- means of connection (42) to link the external contact areas of the card to the means of power supply and control.

4. Test apparatus according to any of claims 1 to 3, **characterized in that** it further comprises:
- means (28) of applying to said tool said force.

5. Test apparatus according to any of claims 1 to 4, **characterized in that** the test means further comprises means (40) for recording the value of the stroke of the tool when said received signals become different from the reference signals

6. Test apparatus according to any of claims 1 to 5, **characterized in that** the portion of the tool for application to the card perpendicular to the electronic module is in the form of a semicylindrical surface of small radius.

7. Test apparatus according to any of claims 1 to 5, **characterized in that** the portion of the tool for being applied to the card perpendicular with the electronic module is a circular plane surface covered in a layer of material that is slightly deformable.

8. Test apparatus according to any one of claims 3 to 7, **characterized in that** said connection means comprise electrical contacts independent of means for applying the force so as to establish electrical connection with the external contact areas of the card when the card is supported via its second face by the longitudinal support elements.

9. Test apparatus according to any one of claims 3 to 7, **characterized in that** said connection means comprise fixed electrical contacts disposed between the two longitudinal support elements to make electrical connections with the external contact areas of the card when said card is resting via its first face on the longitudinal support elements.

10. Test apparatus according to any of claims 1 to 9, **characterized in that** the said longitudinal support elements have a cylindrical shape.

11. Test procedure for electronic memory cards, each comprising a card body (12) having first and second faces and an electronic module (14) comprising both a semiconductor chip (24) in which integrated circuits are formed, and also a plurality of external electrical contact areas (16) connected to said chip and located in said first face incorporates the steps during which:
- the card is subjected to stress in bending and compression by positioning the card on the support (18, 20) and positioning (52, 54) means comprising two longitudinal card face supporting elements disposed in such a manner that the said electronic module is place between the said longitudinal elements and by applying, by means of a moving tool (22) that moves in a direction orthogonal to the plane of the card body y an increasing force perpendicular with said electronic module,
- using the means of control (42), the electronic command signals are applied to said electronic module (14) and the signals delivered received by said module in response to said electrical control signals, **characterized in that** it further comprises the step where:
- the signals received are compared with reference signals representative of proper functioning of integrated circuits in the electronic module at all times that the force is applied, and at least the magnitude of the force (F) applied by the tool is recorded when the received signals become different from the reference signals.

12. Test procedure according to claim 11, **characterized in that** it comprises an additional step according to which the said electronic module is supplied using the power supply means.

13. Test procedure according to claim 12, **characterized in that** it comprises an additional step according to which the external contact areas of the card are connected to supply and control means, by mean of connection.

14. Test procedure according to any of claims 11 to 13, **characterized in that** means (28) are used to apply to said tool said force.

15. Test procedure according to any of claims 11 to 14, **characterized in that** it comprises an additional step according to which the value of the stroke of the tool is recorded when said received signals become different from the reference signals.

16. Test procedure according to any of claims 11 to 15, **characterized in that** the portion of the tool (22) for application to the card perpendicular to the electronic module is in the form of a semicylindrical surface of small radius.

17. Test procedure according to any of claims 11 to 1, **characterized in that** the portion of the tool for being applied to the card perpendicular with the electronic module is a circular plane surface covered in a layer of material that is slightly deformable.

18. Test procedure according to any one of claims 13 to 17, **characterized in that** said connection means comprise electrical contacts independent of means for applying the force so as to establish electrical connection with the external contact areas of the card when the card is supported via its second face by the longitudinal support elements.

19. Test procedure according to any one of claims 13 to 17, **characterized in that** said connection means comprise fixed electrical contacts disposed between the two longitudinal support elements to make electrical connections with the external contact areas of the card when said card is resting via its first face on the longitudinal support elements.

20. Test procedure according to any of claims 11 to 19, **characterized in that** the said longitudinal support elements have a cylindrical shape.

## Patentansprüche

1. Testgerät für elektronische Speicherkarten bestehend aus einem Kartenkörper (12) mit einer ersten und zweiten Seite und einem elektronischen Modul (14) mit einem Halbleiterchip (24), in dem sich integrierte Schaltkreise und mehrere externe elektrische Kontaktbereiche (16) befinden, die an den Halbleiter (24) angeschlossen sind und sich in der ersten Seite befinden, wobei das Gerät umfasst:
- Träger- und Positionierungsmittel (18, 20, 52, 54) der Karte mit zwei längsverlaufenden Trägerelementen (18, 20) einer Seite der Karte, die derart angebracht sind, dass das elektronische Modul (14) zwischen den längsverlaufenden Elementen angeordnet wird,
- ein bewegliches Mittel (22) im rechten Winkel zur Fläche des Kartenkörpers (12), um an der Stelle des elektronischen Moduls (14) eine Kraft (F) zunehmender Intensität auszuüben,
- Kontrollmittel (42), um auf das elektronische Modul (14) elektrische Befehlssignale anzulegen und von dem Modul ausgesandte Signale in Antwort auf die Befehlssignale zu empfangen, wobei das Gerät **dadurch gekennzeichnet** wird, dass es außerdem umfasst:
- Testmittel (34, 36, 38, 40), um die empfangenen Signale mit Bezugssignalen für korrektes Funktionieren der integrierten Schaltkreise des elektronischen Moduls zu jedem Zeitpunkt, zu dem die Kraft angelegt wird, zu vergleichen und um zumindest die Intensität der von dem Mittel ausgeübten Kraft zu speichern, wenn die empfangenen Signale anfangen, sich von den Referenzsignalen zu unterscheiden.

2. Testgerät nach Anspruch 1, **dadurch gekennzeichnet, dass** es außerdem umfasst:
- Mittel (42) zur Versorgung des elektronischen Moduls.

3. Testgerät nach Anspruch 2, **dadurch gekennzeichnet, dass** es außerdem umfasst:
- Verbindungsmittel (42) zur Verbindung der externen Bereiche der Karte mit den Versorgungs- und Kontrollmitteln.

4. Testgerät nach einem der Ansprüche 1 bis 3, **dadurch gekennzeichnet**, das es außerdem umfasst:
- Mittel (28), um die Kraft auf das Mittel anzulegen.

5. Testgerät nach einem der Ansprüche 1 bis 4, **dadurch gekennzeichnet, dass** die Testmittel außerdem Mittel (40) beinhalten, um den Wert des Hubs des Mittels zu speichern, wenn die empfangenen Signale sich von den Bezugssignalen unterscheiden.

6. Testgerät nach einem der Ansprüche 1 bis 5, **dadurch gekennzeichnet, dass** der Teil des Mittels, der auf die Karte in Höhe des elektronischen Moduls angelegt werden soll, die Form einer halbzylindrischen Fläche mit geringem Umkreis einnimmt.

7. Testgerät nach einem der Ansprüche 1 und 5, **dadurch gekennzeichnet, dass** der Teil des Mittels, der auf die Karte in Höhe eines elektronischen Moduls angelegt werden soll, aus einer ebenen, kreisförmigen Fläche besteht, die mit einem leicht verformbaren Material abgedeckt ist.

8. Testgerät nach einem der Ansprüche 3 bis 7, **dadurch gekennzeichnet, dass** die Verbindungsmittel elektrische Kontakte aufweisen, die fest mit den Mitteln verbunden sind, die die Kraft anlegen, um die elektrische Verbindung mit den äußeren Bereichen der Karte herzustellen, wenn diese mit ihrer zweiten Seite auf den längsverlaufenden Trägerelementen ruht.

9. Testgerät nach einem der Ansprüche 3 bis 7, **dadurch gekennzeichnet, dass** die Verbindungsmittel feste elektrische Kontakte umfassen, die zwischen den beiden längsverlaufenden Trägerelementen angebracht sind, um eine elektrische Verbindung mit den externen Bereichen der Karte herzustellen, wenn die Karte mit ihrer ersten Seite auf den längsverlaufenden Trägerelementen ruht.

10. Testgerät nach einem der Ansprüche 1 bis 9, **dadurch gekennzeichnet, dass** die längsverlaufenden Trägerelemente eine zylindrische Form aufweisen.

11. Testverfahren für elektronische Speicherkarten bestehend aus einem Kartenkörper (12) mit einer ersten und zweiten Seite und einem elektronischen Modul (14) mit einem Halbleiterchip (24), in dem sich integrierte Schaltkreise und mehrere externe elektrische Kontaktbereiche (16) befinden, die an den genannten Chip angeschlossen sind und sich in der ersten Seite befinden, das Phasen umfasst, bei denen:
- die Karte gebogen und gestaucht wird, indem die Karte auf Trägermitteln (18, 20) und Positionierungsmitteln (52, 54) angeordnet wird, die längsverlaufende Trägerelemente einer Seite der Karte umfassen, die so angebracht sind, dass das elektronische Modul zwischen den längsverlaufenden Elementen angeordnet wird und mit einem beweglichen Mittel (22) im rechten Winkel zur Fläche des Kartenkörpers in Höhe des elektronischen Moduls eine Kraft mit zunehmender Intensität angelegt wird,
- mit Hilfe von Kontrollmitteln (42) an das elektronische Modul (14) elektrische Befehlssignale angelegt werden und von dem Modul ausgesandte Signale in Antwort auf die Befehlssignale empfangen werden, **dadurch gekennzeichnet, dass** es außerdem die Stufe umfasst, nach der:
- die empfangenen Signale mit den Referenzsignalen des korrekten Betriebs der integrierten Schaltkreise des elektronischen Moduls zu jedem Zeitpunkt verglichen werden, zu dem die Kraft angelegt wird und mindestens die Intensität der von dem Mittel angelegten Kraft (F) gespeichert wird, wenn die empfangenen Signale änfangen, sich von den Referenzsignalen zu unterscheiden.

12. Testverfahren nach Anspruch 11, **dadurch gekennzeichnet, dass** es eine weitere Phase umfasst, in der das genannte elektronische Modul mit Hilfe von Versorgungsmitteln versorgt wird.

13. Testverfahren nach Anspruch 12, **dadurch gekennzeichnet, dass** es eine zusätzliche Phase umfasst, in der die externen Bereiche mit den Versorgungs- und Kontrollmitteln über Verbindungsmittel verbunden werden.

14. Testverfahren nach einem der Ansprüche 11 bis 13, **dadurch gekennzeichnet, dass** die Mittel (28) eingesetzt werden, um an das Mittel die Kraft anzulegen.

15. Testverfahren nach einem der Ansprüche 11 bis 14, **dadurch gekennzeichnet, dass** es eine weitere Phase umfasst, nach der der Hubwert des Mittels gespeichert wird, wenn die empfangenen Signale sich von den Referenzsignalen unterscheiden.

16. Testverfahren nach einem der Ansprüche 11 bis 15, **dadurch gekennzeichnet, dass** der Teil des Mittels (22), der auf die Karte in Höhe des elektronischen Moduls angelegt werden soll, die Form einer halbzylindrischen Fläche mit geringem Umkreis einnimmt.

17. Testverfahren nach einem der Ansprüche 11 bis 15, **dadurch gekennzeichnet, dass** der Teil des Mittels, der auf die Karte in Höhe eines elektronischen Moduls angelegt werden soll, aus einer ebenen, kreisförmigen Fläche besteht, die mit einem leicht verformbaren Material abgedeckt ist.

18. Testverfahren nach einem der Ansprüche 13 bis 17, **dadurch gekennzeichnet, dass** die Verbindungsmittel elektrische Kontakte aufweisen, die fest mit den Mitteln zum Anlegen der Kraft verbunden sind, um die elektrische Verbindung mit den externen Bereichen der Karte herzustellen, wenn diese mit ihrer zweiten Seite auf den längsverlaufenden Trägerelementen ruht.

19. Testverfahren nach einem der Ansprüche 13 bis 17, **dadurch gekennzeichnet, dass** die Verbindungsmittel feste elektrische Kontakte aufweisen, die zwischen den beiden längsverlaufenden Trägerelementen angebracht sind, um eine elektrische Verbindung mit den externen Bereichen der Karte herzustellen, wenn die Karte mit ihrer ersten Seite auf den längsverlaufenden Trägerelementen ruht.

20. Testverfahren nach einem der Ansprüche 11 bis 19, **dadurch gekennzeichnet, dass** die längsverlaufenden Trägerelemente eine zylindrische Form aufweisen.
